## Europäisches Patentamt
## European Patent Office
## Office européen des brevets

(19)

(11) Veröffentlichungsnummer: **0 136 452**
**B1**

(12)

# EUROPÄISCHE PATENTSCHRIFT

(45) Veröffentlichungstag der Patentschrift:
**12.10.88**

(51) Int. Cl.⁴: **G 03 F 7/26**

(21) Anmeldenummer: **84108853.7**

(22) Anmeldetag: **26.07.84**

(54) **Verfahren zur Herstellung von lichtgehärteten Schichten mit definierter Härte.**

(30) Priorität: **05.08.83 DE 3328285**

(43) Veröffentlichungstag der Anmeldung:
**10.04.85 Patentblatt 85/15**

(45) Bekanntmachung des Hinweises auf die Patenterteilung:
**12.10.88 Patentblatt 88/41**

(84) Benannte Vertragsstaaten:
**AT BE CH DE FR GB IT LI NL**

(56) Entgegenhaltungen:
**EP-A-0 054 150**
**GB-A-1 504 215**
**US-A-3 291 630**
**US-A-3 481 738**

**D.J. ELLIOTT: "Integrated circuit fabrication technology", Seiten 145-163, McGraw-Hill Book Company, New York, US**

(73) Patentinhaber: **BASF Aktiengesellschaft, Carl-Bosch- Strasse 38, D-6700 Ludwigshafen (DE)**

(72) Erfinder: **Illers, Karl Heinz, Dr., Huttenstrasse 20, D-6701 Otterstadt (DE)**
Erfinder: **Jun, Mong- Jon, Dr., Maulbeerstueck 20, D-6720 Speyer (DE)**
Erfinder: **Schornick, Gunnar, Dr., Konrad-Adenauer- Strasse 8, D-6719 Neuleiningen (DE)**

0 136 452

**Beschreibung**

Die Erfindung betrifft ein Verfahren zur Herstellung von lichtgehärteten Schichten mit definierter, gezielt einstellbarer Härte durch Bestrahlen mit aktinischem Licht einer einen Photoinitiator enthaltenden lichtempfindlichen Schicht auf Basis eines teilkristallinen Polymeren mit zur Polymerisation befähigten olefinischen Doppelbindungen.

Zur Herstellung von lichtgehärteten Schichten, z. B. Überzügen, photopolymeren Relief- und Druckformen oder Resistmustern, geht man im allgemeinen von lichtempfindlichen Schichten aus photopolymerisierbaren bzw. photovernetzbaren Mischungen aus, die je nach Verwendungszweck vollflächig oder bildmäßig mit aktinischem Licht belichtet werden. Bei bildmäßiger Belichtung können anschließend die nicht belichteten Schichtanteile in geeigneter Weise, z. B. durch Auswaschen mit einem Entwickler-Lösungsmittel, unter Ausbildung einer Reliefstruktur oder eines Resistmusters entfernt werden.

Die zu diesem Zweck bekannten photopolymerisierbaren bzw. photovernetzbaren Mischungen enthalten neben einem Photopolymerisationsinitiator mindestens eine photopolymerisierbare, olefinisch ungesättigte, niedermolekulare und/oder hochmolekulare Verbindung sowie im allgemeinen ein damit verträgliches gesättigtes und/oder ungesättigtes polymeres Bindemittel sowie gegebenenfalls weitere Zusatz- und/oder Hilfsstoffe. Je nach Anwendungszweck sind eine Vielzahl solcher Mischungen auf Basis der verschiedensten polymeren Bindemittel bzw. photopolymerisierbaren Verbindungen beschrieben worden, wie beispielsweise photopolymerisierbare Monomere enthaltende Mischungen auf Basis von Polyamiden (vgl. z. B. FR-A-1 520 865, DE-A-2 202 357, DE-A-2 454 676 oder DE-A-3 047 126), Polyurethanen oder Polyurethan-Polyharnstoffen (vgl. z. B. DE-A-2 404 239) oder auch nieder- und/oder höhermolekulare Polyurethan(meth)acrylate enthaltende Mischungen (vgl. z. B. DE-A-2 140 306, DE-A-2 408 371, DE-A-2 427 494, DE-A-2 641 189, DE-A-2 842 272, DE-A-2 917 748, DE-A-3 047 026 und DE-A-3 131 766) oder Polyurethan-Elastomere mit seitenständigen Allyl- oder Vinyl-Gruppen enthaltende Mischungen (vgl. z. B. US-A-2 948 611, US-A-3 658 351 oder DE-A-2 300 371).

Eine wesentliche anwendungstechnische Eigenschaft ist die Härte der aus den photopolymerisierbaren Mischungen hergestellten gehärteten Schichten. Je nach Anwendungszweck werden dabei zum Teil sehr unterschiedliche Härteanforderungen an diese Schichten gestellt. Bisher mußte dabei die Einstellung der Härte der photopolymerisierten Schicht im wesentlichen über die Rezeptur der photopolymerisierbaren Mischungen erfolgen, d.h. die Zusammensetzung des polymeren Bindemittels und/oder das Mischungsverhältnis von polymerem Bindemittel zu photopolymerisierbaren Verbindungen mußten im Hinblick auf die gewünschte Härte jeweils variiert werden.

Aus der US-A-3 481 738 geht ein Verfahren hervor, bei welchem man eine lichtempfindliche und wärmehärtbare Schicht nach ihrer Herstellung durch ein- bis fünfminütiges Erwärmen auf Temperaturen zwischen 38 und 121°C härtet, wonach man die gehärtete Schicht belichtet. Die lichtempfindliche und wärmehärtbare Schicht enthält als die eine wesentliche Komponente ein lichtempfindliches Polymerisat aus der Gruppe der wasserunlöslichen Vinylpolymerisate, wobei substituierte Vinylpolymerisate bevorzugt werden. Von diesen wiederum werden Polymerisate mit seitenständigen Zimtsäureestergruppen wie beispielsweise Polyvinylalkoholzimtsäureester ganz besonders bevorzugt verwendet. Indessen weisen Polymerisate dieser Art keine zur Photopolymerisation, sondern nur zur Photodimerisation befähigte Doppelbindungen auf. Die andere wesentliche Komponente der lichtempfindlichen und wärmehärtbaren Schicht ist ein wärmehärtbares Harz aus der Gruppe der Melamin-Formaldehydharze und Harnstoff-Formaldehydharze, welches bekanntermaßen beim Erhitzen in der für Formaldehydharze üblichen Weise unter Wasseraustritt chemisch vernetzt, wodurch die wärmehärtbare und lichtempfindliche Schicht vor ihrer Belichtung gehärtet wird. Dieses Verfahren hat den Nachteil, daß es völlig einseitig auf die Härtung von lichtempfindlichen Schichten ausgerichtet ist und überdies hierfür auch noch zwei völlig unterschiedliche Komponenten benötigt, so daß auch hier die Einstellung der Härte der lichtgehärteten Schichten nur über die Variation der Rezeptur, d.h. über das Verhältnis von lichtempfindlichen, wasserunlöslichen Vinylpolymerisat zu wärmehärtbarem Formaldehydharz, erfolgen kann.

Aus der GB-A-1 504 215 ist ein Verfahren zur Trocknung und Härtung ("curing") einer klebrigen photopolymerisierbaren Schicht gleichmäßiger Dicke auf einer Stahlplatte in einem Ofen bekannt. Dieses Verfahren richtet sich ausschließlich auf die Lösung des Problems, die Stahlplatte bei dem Durchgang durch den Ofen völlig plan zu halten. Wird nämlich die Stahlplatte hierbei deformiert, so fließt das klebrige photopolymerisierbare Material von den erhöhten Stellen der Stahlplatte ab und bedeckt deren Oberfläche nicht mehr länger in gleichmäßiger Dicke. Ob und in welcher Weise hierbei das anwendungstechnische Eigenschaftsprofil der nicht näher spezifizierten klebrigen photopolymerisierbaren Schicht geändert wird, läßt sich der GB-A-1 505 215 nicht entnehmen.

Der Übersichtsartikel von D.J. Elliott in "Integrated Curcuit Fabrication Technology" McGraw-Hill Book Company, Hew York, U.S.A., Seiten 145 bis 163, beschäftigt sich ausführlich mit Verfahren für die Entfernung von Lösungsmitteln aus Photoresistmaterialien. Diese Trocknungsverfahren werden dort als "softbaking" bezeichnet. Diese "softbaking"-Verfahren dienen demnach nicht der Modifizierung des anwendungstechnischen Eigenschaftsprofils bereits getrockneter lichthärtbarer Schichten.

Die EP-A-0 054 150 richtet sich auf ein photopolymerisierbares Aufzeichnungsmaterial und ein Verfahren zur Herstellung von Reliefformen mittels dieses Aufzeichnungsmaterials. Das Aufzeichnungsmaterial enthält in seiner photopolymerisierbaren Schicht als Bindemittel ein im wesentlichen lineares, bei Raumtemperaturen festes, hochmolekulares thermoplastisches Polyurethan, das seitenständige photopolymerisierbare Doppelbindungen aufweist. Diese photopolymerisierbare Schicht wird nach ihrer Herstellung durch Gießen

2

**0 136 452**

aus Lösung in üblicher Weise bei 60°C getrocknet, indessen wird sie nicht vor ihrer bildmäßigen Belichtung mit aktinischem Licht einer gezielten Wärmebehandlung unterworfen.

Aufgabe der vorliegenden Erfindung ist es, ausgehend von lichthärtbaren Mischungen bzw. Schichten, ein Verfahren zur Herstellung von Schichten mit definierter Härte aufzuzeigen, bei dem ohne Änderung der Zusammensetzung der lichthärtbaren Mischung bzw. Schicht gezielt lichtgehärtete Schichten unterschiedlicher Härtegrade hergestellt werden können. Das Verfahren soll möglichst universell anwendbar sein und sich insbesondere auch zum Einsatz bei der Herstellung von photopolymeren Druck- und Reliefformen oder Resistmustern eignen, d.h. die einzusetzenden lichthärtbaren Mischungen bzw. Schichten sollen als Aufzeichnungsmaterialien für die optische Informationsfixierung geeignet sein, dementsprechend gute Belichtungseigenschaften und ein hohes Auflösungsvermögen besitzen und neben guten mechanischen Eigenschaften im gehärteten Zustand auch die geforderte chemische Beständigkeit und Resistenz aufweisen.

Es wurde nun überraschend gefunden, daß diese Aufgabe gelöst wird, wenn man eine lichthärtbare, photopolymerisierbare bzw. photovernetzbare Schicht mit einem teilkristallinen polymeren Bindemittel, welches zur Polymerisation befähigte olefinische Doppelbindungen enthält, vor der Lichthärtung der Schicht durch Bestrahlen mit aktinischem Licht einer Wärmebehandlung unterwirft, bei der die teilkristallinen Bereiche des polymeren Bindemittels zumindest teilweise aufgeschmolzen werden, ohne daß dabei jedoch eine chemische Vernetzung oder Härtung erfolgt.

Gegenstand der Erfindung ist demzufolge ein Verfahren zur Herstellung von lichtgehärteten Schichten mit definierter, gezielt einstellbarer Härte durch Bestrahlen einer lichthärtbaren Schicht aus einer photopolymerisierbaren oder photovernetzbaren Mischung von

(a) einem teilkristallinen, polaren Bindemittel mit zur Photopolymerisation befähigten olefinischen Doppelbindungen,
(b) gegebenenfalls einer oder mehreren photopolymerisierbaren, olefinischen ungesättigten niedermolekularen Verbindungen,
(c) mindestens einem photopolymerisationsinitiator,
sowie gegebenenfalls
(d) sonstigen üblichen Zusatz- und/oder Hilfsstoffen

mit aktinischem Licht, bei welchem man die lichthärtbare Schicht vor der Bestrahlung mit dem aktinischen Licht einer Wärmebehandlung unterwirft und welches dadurch gekennzeichnet ist, daß in der lichthärtbaren Schicht als teilkristallines polymeres Bindemittel (a) ein Polyetherester, Polyurethan, Polyurethanharnstoff und/oder ein urethangruppenhaltiges Polyamid mit seitenständigen, vorzugsweise aktivierten, olefinischen Doppelbindungen enthalten ist und daß dabei die Wärmebehandlung so durchgeführt wird, daß keine chemische Vernetzung oder Härtung der lichthärtbaren Schicht erfolgt, sondern daß die teilkristallinen Bereiche des polymeren Bindemittels (a) in Abhängigkeit von der angewandten Temperatur zumindest teilweise aufgeschmolzen werden. Insbesondere darf bei der Wärmebehandlung auf gar keinen Fall eine chemische Vernetzung oder Härtung erfolgen, wenn nach diesem Verfahren Druck- und Reliefformen oder Resistmuster hergrstellt werden sollen.

Es hat sich überraschend gezeigt, daß sich durch eine erfindungsgemäße Wärmebehandlung vor der Lichthärtung bei Schichten der in Rede stehenden Art die Härte der lichtgehärteten Schicht beeinflussen und in Abhängigkeit von den Bedingungen der Wärmebehandlung, insbesondere deren Dauer und Höhe der Temperatur, in weiten Grenzen variieren und gezielt einstellen läßt. Es ist anzunehmen, daß die bei der Wärmebehandlung aufgeschmolzenen teilkristallinen Bereiche des polymeren Bindemittels bei der nachfolgenden Lichthärtung der Schicht so fest und dauerhaft fixiert werden, daß sie anschließend nicht mehr oder nicht mehr in vollem Ausmaße rekristallisieren können. Es hat sich ferner gezeigt, daß durch das zumindest teilweise Aufschmelzen der teilkristallinen Bereiche des polymeren Bindemittels (a) und die anschließende Fixierung dieses Zustandes bei der Lichthärtung andere wesentliche anwendungstechnische Eigenschaften der lichthärtbaren bzw. der lichtgehärteten Schichten, wie z. B. mechanische Festigkeit, Elastizität, chemische Beständigkeit, Belichtungs eigenschaften, Auflösungsvermögen, nicht beeinträchtigt werden, so daß das erfindungsgemäße Verfahren in breitem Maße, insbesondere auch bei der Herstellung von Druck- und Reliefformen oder Resistmustern aus lichtempfindlichen Aufzeichnungsmaterialien für die optische Informationsfixierung, anwendbar ist.

Das erfindungsgemäße Verfahren geht von lichthärtbaren Schichten photopolymerisierbarer bzw. photovernetzbarer Mischungen aus, die ein teilkristallines polymeres Bindemittel mit zur Polymerisation befähigten olefinischen Doppelbindungen enthalten. Die lichthärtbaren Schichten können dabei selbsttragend sein, sie können jedoch auch auf einem in aller Regel festen Untergrund oder Trägermaterial aufgebracht sein. Für die Herstellung von Überzügen, z. B. als Schutzschihten oder zu Dekorationszwecken, eignen sich beliebige Substrate als Untergründe, wie z. B. Metalle, Holz, Kunststoffe, Papier oder Pappe. Bei lichtempfindlichen Aufzeichnungsmaterialien zur optischen Informationsfixierung, z. B. für die Herstellung von Druck- oder Reliefformen, ist die lichthärtbare Schicht im allgemeinen auf dimensionsstabilen, starren oder flexiblen Trägern aus Metallen, z. B. Stahl-, Aluminium- oder Kupfer-Blechen, oder Kunststoff-Filmen oder -Folien, z. B. aus Polyethylenterephthalat oder Polybutylenterephthalat, haftfest aufgebracht. Bei der Herstellung von Resistmustern dienen als Trägermaterialien beispielsweise Kupferplatinen, Leiterplatten, gedruckte Schaltungen.

3

**0 136 452**

Die in den erfindungsgemäßen Verfahren einzusetzende lichthärtbare Schicht enthält als eine wesentliche Komponente mindestens ein teilkristallines polymeres Bindemittel (a), welches zur radikalischen Polymerisation befähigte olefinische Doppelbindungen im Molekül eingebaut enthält. Diese polymerisierbaren, olefinischen Doppelbindungen können in der Polymerhauptkette des teilkristallinen, polymeren Bindemittels eingebaut sein, vorzugsweise sind sie jedoch seitenständig und/oder endständig an die Polymerhauptkette gebunden. Vorzugsweise handelt es sich bei den olefinischen Doppelbindungen um aktivierte Doppelbindungen, die in Konjugation oder in Nachbarschaft zu O-, S- oder H-Atomen oder zu anderen Kohlenstoff-Kohlenstoff-Mehrfachbindungen stehen, insbesondere um Acryloyl- und/oder Methacryloyl-Gruppen. Der Gehalt an den polymerisierbaren olefinischen Doppelbindungen in den teilkristallinen polymeren Bindemitteln (a) beträgt im allgemeinen 0,01 bis 3 Gew.-%, bezogen auf das Gewicht des polymeren Bindemittels (a), wobei das Gewicht der polymerisierbaren olefinischen Doppelbindung mit 24 gerechnet ist. Der Anteil der polymerisierbaren olefinischen Doppelbindungen in dem teilkristallinen polymeren Bindemittel (a) richtet sich unter anderem sowohl nach der Reaktivität der Doppelbindungen als auch nach der Art des teilkristallinen polymeren Bindemittels (a) allgemein. Die Anzahl dieser Doppelbindungen ist nach unten dadurch begrenzt, daß sie hinreichen muß, die Polymeren in dem Zustand nach der Wärmebehandlung zu fixieren, und wird nach oben durch den maximal gewünschten Vernetzungsgrad der Schicht nach der Belichtung und Härtung bestimmt, der nur so groß sein soll, daß noch eine deutliche Abhängigkeit der mechanischen Eigenschaften der gehärteten Schicht von dem teilkristallinen polymeren Bindemittel (a) und der Höhe der Teilkristallinität gegeben ist.

Die in aller Regel festen, teilkristallinen polymeren Bindemittel (a) sind vorzugsweise im wesentlichen linear und besitzen vorteilhaft einen K-Wert zwischen 20 und 75, insbesondere in Bereich von etwa 30 bis 65. Die Bestimmung der K-Werte erfolgt nach Fikentscher, Cellulose-Chemie 13, (1932) 58.

Als teilkristalline polymere Bindemittel (a) werden Polyurethane, wie Polyetherurethane, Polyesterurethane oder Polyurethanpolyharnstoffe; Polyamide oder Urethangruppen enthaltende Polyamide; Polyetherester verwendet, welche polymerisierbare olefinische Doppelbindungen eingebaut enthalten. Derartige teilkristalline Polymere sowie ihre Herstellung sind an sich bekannt und in der Literatur beschrieben.

Als teilkristalline polymere Bindemittel (a) geeignete Polyurethane und Polyurethan-Polyharnstoffe werden in an sich üblicher Weise durch Umsetzung von Diisocyanaten mit höhermolekularen Polydiolen, geeigneten olefinisch ungesättigten Verbindungen, die eine, vorzugsweise zwei im Sinne der Isocyanatchemie reaktionsfähige Wasserstoffatome enthalten, sowie gegebenenfalls weiteren, für die Herstellung von Polyurethanen üblichen niedermolekularen Kettenverlängerern, wie Diolen, Aminoalkoholen und/oder Diaminen, hergestellt Als Diisocyanate kommen im Prinzip beliebige aliphatische, cycloaliphatische, araliphatische, aromatische oder heterocyclische Diisocyanate in Betracht. Als Polydiole sind die im wesentlichen linearen, bekannten Polyetherdiole, Polyesterdiole, Polylactondiole sowie Polycarbonatdiole zu nennen. Das Molekulargewicht der Polydiole liegt im allgemeinen zwischen 250 und 4000, vorzugsweise zwischen 500 und 2000. Bei den gegenüber Isocyanaten reaktiven, olefinisch ungesättigten Verbindungen handelt es sich insbesondere um Verbindungen mit mindestens einer photopolymerisierbaren, olefinischen, vorzugsweise aktivierten Doppelbindung, die mindestens eine, insbesondere jedoch zwei Hydroxyl- und/oder Aminogruppen enthalten. Als Kettenverlängerer kommen weitere niedermolekulare Diole, Diamine oder Aminoalkohole, im allgemeinen mit Molekulargewichten zwischen 60 und 400, in Betracht, wobei der Einsatz solcher zusätzlichen Kettenverlängerungsmittel unter anderem auch von den angestrebten Eigenschaften des Polyurethans abhängt. So führt beispielsweise der Einsatz von Diaminen zur Bildung von Harnstoff-Gruppen im Polyurethan, wodurch härtere Produkte gebildet werden.

Die teilkristallinen Polyurethane oder Polyurethan-Polyharnstoffe enthalten in der Regel 10 bis 40 Gew.-%, vorzugsweise 15 bis 30 Gew.-%, an Diisocyanaten, 30 bis 85 Gew.-%, vorzugsweise 45 bis 70 Gew.-% an Polydiolen, 0,1 bis 20 Gew.-%, insbesondere etwa 0,5 bis 15 Gew.-%, an gegenüber Isocyanaten reaktiven, olefinisch ungesättigten Verbindungen sowie 0 bis 20 Gew.-%, vorzugsweise 1 bis 15 Gew.-%, an weiteren niedermolekularen Kettenverlängerern, wobei die Prozentangaben jeweils auf das Polyurethan bzw. den Polyurethan-Polyharnstoff bezogen sind. Dabei werden die Komponenten zur Herstellung der Polyurethane bzw. Polyurethan-Polyharnstoffe im allgemeinen in einem solchen Verhältnis zueinander eingesetzt, daß das NCO/OH,NH-Molverhältnis etwa 0,8 bis 1,3, insbesondere etwa 0,9 bis 1,2, beträgt.

Als sehr günstig für den Einsatz in dem erfindungsgemäßen Verfahren haben sich lichthärtbare Schichten erwiesen, die als teilkristallines polymeres Bindemittel (a) solche Polyurethane bzw. Polyurethan-Polyharnstoffe mit zur Polymerisation befähigten olefinischen Doppelbindungen enthalten, die aufgebaut sind aus aliphatischen oder cycloaliphatischen Diisocyanaten, wie z. B. Dicyclohexylmethandiisocyanat, Hexamethylendiisocyanat, Isophorondiisocyanat oder Trimethylhexamethylendiisocyanat; im wesentlichen linearen Polyetherdiolen, Polyesterdiolen und/oder Polyether-Polyesterdiolen, wie z. B. Polyethylenglykolen, Polymeropylenglykolen, Ethylenglykol-/Propylenglykol-Mischkondensationsprodukten, Polymerisationsprodukten des Tetrahydrofurans und Butylenoxids, Veresterungsprodukten von Dicarbonsäuren, insbesondere Adipinsäure, mit $C_2$- bis $C_{10}$-Alkandiolen oder Oxalkandiolen mit 2 bis 6 C-Atomen, z. B. Adipate mit Glykol, Diethylenglykol, Butandiol-1,4, Hexandiol-1,6 und/oder 2,2-Dimethylpropandiol-1,3; Diolen mit einfachen, polymerisierbaren, olefinischen Doppelbindungen, wie z. B. Butendiol-1,4, Butendiol-2,3, Dimethylolnorbonen oder Dimethylolcyclohexen, oder vorzugsweise aus kettenverlängernden, ungesättigten Carbonsäureesterdiolen, wie z. B. dem Reaktionsprodukt von Dicarbonsäuren mit polymerisierbaren olefinisch ungesättigten Glycidylverbindungen, dem

4

Umsetzungsprodukt aus Glycidol und (Meth)Acrylsäure oder den Umsetzungsprodukten von Diepoxiden, beispielsweise auf Basis von Bisphenol A, mit $\alpha,\beta$-ungesättigten Carbonsäuren, insbesondere (Meth)Acrylsäure; sowie aus niedermolekularen Diolen, Aminoalkoholen oder Diaminen als Kettenverlängerern, wobei diese Verbindungen gegebenenfalls auch tertiäre Stickstoffatome eingebaut enthalten können, wie z. B. Ethylenglykol, Propandiol, Butandiol, Neopentylglykol, Hexandiol, Ethanolamin, N-Methylethanolamin, Ethylendiamin, Hexamethylendiamin, N-Methyldiethanolamin, N-Ethyldiethanolamin oder N-Ethyldiisopropanolamin. Erfindungsgemäß geeignete, teilkristalline Polyurethane bzw. Polyurethan-Polyharnstoffe mit polymerisierbaren, olefinischen Doppelbindungen sind beispielsweise in der US-A-2 948 611, der DE-A-2 300 371, sowie insbesondere der DE-A-3 047 026 und der DE-A-3 131 766 beschrieben.

Neben den Polyurethanen und Polyurethan-Polyharnstoffen werden als teilkristalline polymere Bindemittel (a) auch Polyamide mit photopolymerisierbaren, olefinischen Doppelbindungen verwendet. Derartige Polyamide werden aus olefinisch ungesättigten Diaminen und aliphatisch gesättigten Dicarbonsäuren, aus Diaminen und olefinisch ungesättigten Dicarbonsäuren oder aus olefinisch ungesättigten Lactamen in an sich bekannter Art und Weise hergestellt. Als vorteilhaft haben sich solche Polyamide mit polymerisierbaren, olefinischen Doppelbindungen erwiesen, die aufgebaut sind aus gesättigten aliphatischen, cycloaliphatischen oder aromatischen Diaminen, z. B. Polyurethylendiaminen, wie Hexamethylendiamin oder Dekamethylendiamin, Diaminodicyclohexylmethan oder Diaminodiphenylmethan; $\alpha,\beta$-olefinisch ungesättigten Dicarbonsäuren, wie insbesondere Maleinsäure, Fumarsäure oder Tetrahydrophthalsäure bzw. deren Anhydriden; sowie gegebenenfalls weiteren gesättigten, aliphatischen, cycloaliphatischen oder aromatischen Dicarbonsäuren, wie z. B. Adipinsäure, Glutarsäure, Hexahydrophthalsäure oder Terephthalsäure.

Außerdem werden als teilkristalline polymere Bindemittel (a) in der lichthärtbaren Schicht auch urethangruppenhaltige Polyamide verwendet, bei denen die polymerisierbaren olefinischen Doppelbindungen beispielsweise als seitenständige Gruppen enthalten sind. Solche urethangruppenhaltigen Polyamide werden durch Umsetzung von üblichen, insbesondere aliphatisch gesättigten Polyamiden (aus gesättigten aliphatischen, cycloaliphatischen und/oder aromatischen Dicarbonsäuren und gesättigten aliphatischen, cycloaliphatischen und/oder aromatischen Diaminen, aus Aminocarbonsäuren oder Lactamen), die zwei endständige Amino- und/oder Hydroxylgruppen enthalten, mit Diisocyanaten, vorzugsweise aliphatischen oder cycloaliphatischen Diisocyanaten (z. B. Dicyclohexylmethandiisocyanat, Hexamethylendiisocyanat, Isophorondiisocyanat oder Trimethylhexamethylendiisocyanat), niedermolekularen Diolen, Diaminen oder Aminoalkoholen mit polymerisierbaren, olefinischen Doppelbindungen sowie gegebenenfalls weiteren niedermolekularen Diolen, Diaminen oder Aminoalkoholen als Kettenverlängerern hergestellt. Bei den Diolen, Diaminen oder Aminoalkoholen mit den polymerisierbaren, olefinischen Doppelbindungenhandelt es sichum solche Verbindungen mit einfachen olefinischen Doppelbindungen, wie beispielsweise Butendiol-1,4, Butendiol-2,3, Dimethylolnorbonen oder Dimethylolcyclohexen, vorzugsweise jedoch um Verbindungen mit aktivierten olefinischen Doppelbindungen, insbesondere ungesättigten Carbonsäureesterdiolen, wie den Umsetzungsprodukten von Dicarbonsäuren mit polymerisierbaren, olefinisch ungesättigten Glycidylverbindungen, dem Umsetzungsprodukt von Glycidol mit (Meth)Acrylsäure oder den Reaktionsprodukten von Diepoxidverbindungen (z. B. auf Basis von Bisphenol A) mit $\alpha,\beta$-ungesättigten Monocarbonsäuren, insbesondere (Meth)Acrylsäure. Werden bei der Herstellung der urethangruppenhaltigen Polyamide weitere Diole, Diamine oder Aminoalkohole als Kettenverlängerer mitverwendet, so enthalten diese beispielsweise auch tertiäre Stickstoffatome, die auf diese Weise mit in die urethangruppenhaltigen Polyamide eingebaut werden.

Vorteilhafte urethangruppenhaltige Polyamide enthalten etwa 15 bis 65 Gew.-%, insbesondere 20 bis 55 Gew.-%, der Polyamid-Bausteine, vorzugsweise mit einem Molekulargewicht im Bereich von 500 bis 10.000, insbesondere von 700 bis 5000; 10 bis 50 Gew.-%, insbesondere 15 bis 45 Gew.-% an Diisocyanaten; 0,1 bis 20 Gew.-%, insbesondere 0,5 bis 15 Gew.-% der gegenüber Isocyanat reaktiven Verbindungen mit den polymerisierbaren, olefinischen Doppelbindungen sowie 0 bis 30 Gew.-%, insbesondere 2 bis 25 Gew.-% an sonstigen niedermolekularen oder hochmolekularen Kettenverlängerern, wobei die Prozentangaben jeweils auf das urethangruppenhaltige Polyamid bezogen sind. Zur Herstellung der urethangruppenhaltigen Polyamide werden dabei im allgemeinen die einzelnen Komponenten in einem solchen Verhältnis zueinander eingesetzt, daß das NCO/OH,NH-Molverhältnis etwa 0,8 bis 1,85, insbesondere etwa 0,9 bis 1,2, beträgt. Geeignete urethangruppenhaltige Polyamide mit quaternären bzw. quaternisierbaren Stickstoff-Atomen werden beispielsweise in der DE-A-3 047 126 beschrieben, wobei auch entsprechende urethangruppenhaltige Polyamide ohne quaternäre bzw. quaternisierbare Stickstoffatome sehr gut geeignet sind.

Des weiteren werden als teilkristalline polymere Bindemittel (a) die Polyetherpolyester verwendet, wie sie in an sich üblicher Weise durch Umsetzung von Polyetherdiolen allein oder im Gemisch mit niedermolekularen Diolen mit Dicarbonsäuren zugänglich sind, wobei die polymerisierbaren olefinischen Doppelbindungen entweder über die Diolkomponente oder die Dicarbonsäure-Komponente eingeführt werden. Vorteilhafte Polyetherester werden hergestellt aus Polyetherdiolen mit einem Molekulargewicht im allgemeinen zwischen 250 und 4000, vorzugsweise zwischen 500 und 3000, insbesondere Polyalkylenoxiden, wie Polyethylenoxid, Polypropylenoxid, Ethylenoxid-/Propylenoxid-Mischkondensationsprodukten oder Polybutylenoxid; gesättigten aliphatischen, cycloaliphatischen oder aromatischen Dicarbonsäuren, wie insbesondere Adipinsäure, Glutarsäure, Hexahydrophthalsäure, Phthalsäure, Terephthalsäure oder deren Derivaten, insbesondere deren Anhydriden; olefinisch ungesättigten Diolen und/oder olefinisch ungesättigten Dicarbonsäuren, wie z. B. Butendiol-1,4, Butendiol-2,3, Vinylglykol, Dimethylolnorbonen, Dimethylolcyclohexen, ungesättigten Carbonsäureesterdiole, insbesondere der weiter oben genannten Art, Maleinsäure, Fumarsäure oder Tetrahydrophthalsäure; sowie vorzugsweise weiteren niedermolekularen aliphatisch gesättigten Diolen mit Molekulargewichten insbesondere zwischen 62 und 400 als Kettenverlängerern, wie z. B. Ethylenglykol, Kondensaten des Ethylenglykols, Propandiol, Butandiol, Hexandiol, Dekandiol, Cyclohexandiol, Cyclohexandimethanol oder ethoxyliertem Bisphenol A. Als sehr günstig haben sich solche Polyetherester erwiesen, die 20 bis 50 Gew.-% an Polyetherdiolen, 10 bis 40 Gew.-% an aliphatisch gesättigten Dicarbonsäuren, 0,5 bis 20 Gew.-% an olefinisch ungesättigten Diolen und/oder olefinisch ungesättigten Dicarbonsäuren sowie 0,5 bis 20 Gew.-% an weiteren niedermolekularen aliphatisch gesättigten Diolen eingebaut enthalten, wobei sich die Prozentangaben jeweils auf den Polyetherester beziehen.

Die in dem erfindungsgemäßen Verfahren einzusetzende lichthärtbare Schicht kann neben dem oder den teilkristallinen polymeren Bindemitteln mit zur Polymerisation befähigten olefinischen Doppelbindungen (a), gegebenenfalls auch noch niedermolekulare, photopolymerisierbare, olefinisch ungesättigte Verbindungen (b) enthalten. Der Zusatz von solchen niedermolekularen photopolymerisierbaren Verbindungen (b) in der lichthärtbaren Schicht hängt dabei unter anderem von der Anzahl der photopolymerisierbaren olefinischen Doppelbindungen in dem teilkristallinen polymeren Bindemittel (a), den gewünschten Belichtungs- und Härtungseigenschaften sowie dem sonstigen angestrebten Eigenschaftsbild ab. Wenn in der lichthärtbaren Schicht niedermolekulare, photopolymerisierbare, olefinisch ungesättigte Verbindungen (b) enthalten sind, so sind diese vorzugsweise - insbesondere dann, wenn das erfindungsgemäße Verfahren zur Herstellung von Druck- und Reliefformen oder Resistmustern eingesetzt werden soll - mit dem teilkristallinen polymeren Bindemittel (a) verträglich.

Als photopolymerisierbare, olefinisch ungesättigte niedermolekulare Verbindungen (b) kommen die an sich für lichthärtbare Schichten bekannten Monomeren und/oder Oligomeren (mit einem Molekulargewicht im allgemeinen bis zu etwa 5000, vorzugsweise mit einem Molekulargewicht bis zu etwa 3000) in Frage. Die niedermolekularen, photopolymerisierbaren Verbindungen (b) können monofunktionell oder mehrfunktionell sein, d.h. sie können eine oder mehrere photopolymerisierbare olefinische Doppelbindungen besitzen. Gleichermaßen können auch Mischungen von mono- und mehrfunktionellen niedermolekularen photopolymerisierbaren Verbindungen (b) eingesetzt werden. Für die Herstellung von Überzügen und schnellvernetzende härtbare Schichten sind insbesondere die mehrfunktionellen Verbindungen (b) geeignet. Für die Herstellung von weichelastischen, gehärteten Schichten, insbesondere von weichelastischen Reliefdruckformen hat sich der Einsatz von monofunktionellen Verbindungen (b) oder von Mischungen von mono- und mehrfunktionellen Verbindungen (b), die 1 bis 30 Gew.-%, vorzugsweise 2 bis 20 Gew.-%, bezogen auf die Mischung, an mehrfunktionellen Verbindungen (b) enthalten, als günstig erwiesen.

Als Beispiele für niedermolekulare, photopolymerisierbare, olefinisch ungesättigte Verbindungen (b) seien genannt: Vinylverbindungen, wie z. B. Vinylether und Vinylester; α,β-olefinisch ungesättigte Mono- oder Dicarbonsäuren sowie insbesondere deren Derivate, z. B. Malein- oder Fumarsäure, deren Alkylester, insbesondere mit 1 bis 8 C-Atomen im Alkylrest, sowie besonders bevorzugt Acrylsäure und/oder Methacrylsäure und deren Derivate, wie (Meth)acrylnitril, (Meth)acrylamid, N-Methylol-(meth)acrylamid, Veretherungsprodukte der N-methylolierten (Meth)acrylamide z. B. vom Typ des Glykolamols, sowie die Ester der Acrylsäure und/oder Methacrylsäure mit ein- oder mehrwertigen Alkoholen. Hierzu gehören beispielsweise die Di- und Poly-(meth)acrylate von Alkylenglykolen, Polyalkylenglykolen und mehrwertigen Alkanolen mit 2 bis 20 C-Atomen, wie die Di- und Poly(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, Neopentylglykol, 1,4-Butandiol, 1,1,1-Trimethylolpropan, Glycerin oder Pentaerythrit; ferner die Monoacrylate und Monomethacrylate solcher Diole und Polyole, wie z. B. Ethylenglykol-, Di-, Tri- oder Tetraethylenglykol-mono(meth)acrylate, 1,4-Butandiol-mono(meth)acrylat oder Hexandiol-mono(meth)acrylat, die (Meth)acrylate von Monoalkoholen mit 1 bis 20 C-Atomen, wie Methyl(meth)acrylat, Ethyl(meth)acrylat, Propyl(meth)acrylat, Butyl(meth)acrylat, Hexyl(meth)acrylat oder 2-Ethylhexyl(meth)acrylat; sowie Monomere oder Oligomere mit zwei oder mehr olefinisch ungesättigten Doppelbindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen oder die Umsetzungsprodukte von (Meth)acrylsäure mit aromatischen und/oder aliphatischen Diglycidylethern als auch niedermolekulare Polyesteracrylate.

Die in dem erfindungsgemäßen Verfahren einzusetzenden lichthärtbaren Schichten enthalten im allgemeinen 50 bis 100 Gew.-%, vorzugsweise 60 bis 95 Gew.-% des teilkristallinen polymeren Bindemittels (a) sowie 0 bis 50 Gew.-%, vorzugsweise 5 bis 40 Gew.-%, der niedermolekularen, photopolymerisierbaren, olefinisch ungesättigten Verbindungen (b), jeweils bezogen auf die Summe der Komponenten (a) + (b). Sind in der lichthärtbaren Schicht mehrfunktionelle, niedermolekulare, olefinisch ungesättigte Verbindungen (b) enthalten, liegt ihr Anteil im allgemeinen nicht über 15 Gew.%, vorzugsweise nicht über 10 Gew.-%, bezogen auf die Summe der Komponenten (a) + (b).

Des weiteren enthält die erfindungsgemäß einzusetzende lichthärtbare Schicht einen oder mehrere Photopolymerisationsinitiatoren (c). Hierfür kommen die an sich bekannten und üblichen Verbindungen und Systeme zur Auslösung einer Photopolymerisationsreaktion in lichthärtbaren Massen bei Bestrahlung mit aktinischem Licht in Frage, wie sie hinreichend in der einschlägigen Fachliteratur beschrieben sind. Hierzu gehören neben Acyloinen und deren Derivaten, wie Benzoin, Benzoinalkylether, α-Methylolbenzoin und dessen

6

**0 136 452**

Ether, α-Methylbenzoin und dessen Ether, insbesondere die vicinalen Diketone und deren Derivate, wie z. B. Benzil und Benzilketale, insbesondere Benzildimethylketal, Benzilmethylethylketal, Benzilmethylbenzylketal oder Benzilethylenglykolketal. Eine weitere Gruppe von besonders vorteilhaften Polymerisationsinitiatoren sind die Acylphosphinverbindungen, wie beispielsweise in DE-A-2 830 927, DE-A-2 909 994, DE-A-3 020 092, DE-A-3 034 697, DE-A-3 114 341 und DE-A-3 133 419 beschrieben sind. Beispielhaft hierfür seien genannt das 2,6-Dimethoxybenzoyl-diphenylphosphinoxid, das 2,4,6-Trimethylbenzoyl-diphenylphosphinoxid, der 2,4,6-Trimethylbenzoyl-phenylphosphinsäureethylester und das 2,4,6-Trimethylbenzoyl-bis(o-tolyl)-phosphinoxid. Zu den Photopolymerisationsinitiatoren gehören auch unsubstituierte oder substituierte Chinone, wie z. B. Anthrachinon und Benzanthrachinon sowie Benzophenon und dessen Derivate, insbesondere 4,4'-Bis-(dimethylamino)-benzophenon. Die Photopolymerisationsinitiatoren (c) sind in der lichthärtbaren Schicht im allgemeinen in Mengen von 0,01 bis 10 Gew.-%, vorzugsweise von 0,05 bis 5 Gew.-%, bezogen auf die gesamte lichthärtbare Schicht, enthalten.

Darüber hinaus können in der lichthärtbaren Schicht gegebenenfalls weitere sonstige, übliche Zusatz- und/oder Hilfsstoffe (d) in hierfür üblichen Mengen enthalten sein. Hierzu gehören insbesondere thermische Polymerisationsinhibitoren, anorganische oder organische Pigmente und Farbstoffe, anorganische oder organische Füllstoffe, Weichmacher, Mattierungs- oder Gleitmittel, gegebenenfalls weitere polymere Bindemittel, die mit den als Komponente (a) in der Schicht enthaltenen teilkristallinen polymeren Bindemitteln verträglich sind, sensitometrische Regler, wenn das erfindungsgemäße Verfahren zur optischen Informationsfixierung, insbesondere zur Herstellung von Druck- oder Reliefformen oder Resistmustern dient, etc. Die sonstigen üblichen Zusatz- und/oder Hilfsstoffe (d) sind in der lichthärtbaren Schicht im allgemeinen in Mengen bis maximal 50 Gew.-%, insbesondere in Mengen bis zu 20 Gew.-%, bezogen auf die lichthärtbare Schicht, enthalten.

Die Herstellung der in dem erfindungsgemäßen Verfahren einzusetzenden lichthärtbaren Schicht kann in an sich bekannter Weise durch homogenes Vermischen der einzelnen Komponenten und Formen dieser photopolymerisierbaren bzw. photovernetzbaren Mischung zu einer Schicht der gewünschten Schichtdicke erfolgen. Das homogene Vermischen der Komponenten kann nach den üblichen Knet-, Misch- oder Lösungsverfahren vorgenommen werden. Die lichthärtbaren Schichten können dann beispielsweise aus Lösungen der Gemische in geeigneten Lösungsmitteln, z. B. Tetrahydrofuran, Toluol durch Gießen auf ein geeignetes Trägermaterial, Verdampfen des Lösungsmittels und Trocknen der Schicht hergestellt werden. Ebenso können die lichthärtbaren Schichten durch Pressen, Kalandrieren oder Extrudieren der homogenen, photopolymerisierbaren bzw. photovernetzbaren Mischungen gebildet werden, wobei diese so geformten Schichten gewünschtenfalls anschließend oder gleichzeitig auf einen Träger aufgebracht werden können. Die Schichtdicke der bei Raumtemperatur im allgemeinen festen lichthärtbaren Schichten hängt von dem jeweiligen Anwendungszweck der lichtgehärteten Schichten ab und kann daher in weiten Grenzen schwanken. Da sich das erfindungsgemäße Verfahren gleichermaßen zur Herstellung von Überzügen, Beschichtungen oder Resistmustern, aber auch zur Herstellung von Druckformen, Reliefformen oder selbsttragenden Filmen oder Folien eignet, kommen für die in diesem Verfahren einzusetzenden lichthärtbaren Schichten Dicken im Bereich von einigen µm, z. B. von 1 bis 2 µm, bis zu einigen mm, beispielsweise 5 bis 6 mm, in Betracht.

Erfindungsgemäß werden die lichthärtbaren Schichten zur Herstellung der lichtgehärteten Schichten mit definierter Härte zunächst einer Wärmebehandlung unterworfen, bei der die teilkristallinen Bereiche des polymeren Bindemittels (a) zumindest teilweise aufgeschmolzen werden. Die Höhe der Temperatur für diese Wärmebehandlung richtet sich nach dem in der lichthärtbaren Schicht enthaltenen teilkristallinen, polymeren Bindemittel (a). Darüber hinaus ist sie in Korrelation mit der Dauer der Wärmebehandlung auch abhängig von dem Umfang, in dem die teilkristallinen Bereiche des polymeren Bindemittels (a) aufgeschmolzen werden sollen. Allgemein sollen somit die Temperaturen für die Wärmebehandlung über den Schmelztemperaturen für die teilkristallinen Bereiche der polymeren Bindemittel (a) liegen, jedoch unterhalb von den Temperaturen, bei denen die polymeren Bindemittel (a) bzw. die lichthärtbaren Schichten thermisch geschädigt werden. Soll das erfindungsgemäße Verfahren für die optische Informationsfixierung, d.h. also z. B. für die Herstellung von Relief- und Druckformen oder Resistmustern, eingesetzt werden, so ist darauf zu achten, daß die Wärmebehandlung bei solchen Temperaturen durchgeführt wird, bei denen noch keine chemische Vernetzung oder Härtung der Schicht erfolgt, da anderenfalls nach der nachfolgenden bildmäßigen Belichtung und Lichthärtung die Entwicklung der Reliefstrukturen bzw. Resistmuster beeinträchtigt werden könnte. Im allgemeinen haben sich für die erfindungsgemäße Wärmebehandlung Temperaturen im Bereich von 50 bis 130°C, insbesondere im Bereich von 60 bis 120°C, als zweckmäßig und sehr vorteilhaft erwiesen.

Die Dauer für die erfindungsgemäße Wärmebehandlung ist abhängig von der hierfür gewählten Temperatur und insbesondere von der gewünschten Härte der Schicht nach der Lichthärtung. Je länger die Temperaturbehandlung durchgeführt wird, d.h. je größer der Anteil der teilkristallinen Bereiche des polymeren Bindemittels (a) ist, der hierbei aufgeschmolzen wird, desto weichelastischer und weniger hart ist die nach der Lichthärtung resultierende gehärtete Schicht. Die Dauer für die Wärmebehandlung liegt im allgemeinen im Bereich von 1 bis 120 Minuten; insbesondere haben sich Behandlungszeiten im Bereich von 5 bis 60 Minuten als vorteilhaft und ausreichend erwiesen. Die Wärmebehandlung kann grundsätzlich auch in mehreren Stufen bei zwei oder mehreren verschiedenen Temperaturen durchgeführt werden. Im Vergleich zu einer Wärmebehandlung bei einer konstanten Temperatur werden hierdurch jedoch im allgemeinen keine nennenswerten Vorteile bezüglich der Eigenschaften der resultierenden lichtgehärteten Schicht erzielt. Die Wärmebehandlung selber kann in jeder geeigneten Weise und mit beliebigen, geeigneten Mitteln und

7

**0 136 452**

Vorrichtungen vorgenommen werden. Beispielsweise kann die Wärmebehandlung durch Beaufschlagen der lichthärtbaren Schicht mit warmer Luft, z. B. in einem Ofen, erfolgen. Es ist jedoch auch möglich, die notwendige Wärme in die lichthärtbare Schicht über eine Wärmestrahlung einzubringen, indem man beispielsweise die Schicht mit IR-Strahlern bestrahlt. Vorteilhafterweise wird die Wärmebehandlung der lichthärtbaren Schicht so durchgeführt, daß die Schicht gleichmäßig und von allen Seiten dem wärmeerzeugenden bzw. -übertragenden Medium ausgesetzt ist.

Im Anschluß an die Wärmebehandlung wird die Schicht durch Bestrahlung mit aktinischem Licht gehärtet. Die Lichthärtung kann dabei unmittelbar im Anschluß an die Wärmebehandlung erfolgen. Es ist jedoch auch möglich, die wärmebehandelte, lichthärtbare Schicht erst nach einer Zwischenlagerung mit dem aktinischen Licht zu bestrahlen und zu härten. Die Zeit zwischen Wärmebehandlung und Lichthärtung darf jedoch nicht so groß sein, daß die aufgeschmolzenen teilkristallinen Bereiche des polymeren Bindemittels (a) wieder rekristallisieren. Es hat sich als sehr vorteilhaft erwiesen, die lichthärtbare Schicht nach der Wärmebehandlung zunächst wieder auf Raumtemperatur abkühlen zu lassen, was im allgemeinen 5 bis 15 Minuten dauert, und anschließend möglichst unverzüglich die Schicht durch Bestrahlung mit aktinischem Licht zu härten. Falls zwischen Wärmebehandlung und Lichthärtung eine Zwischenlagerung erfolgen soll, soll diese möglichst 60 Minuten nicht überschreiten. In manchen Fällen kann es auch günstig sein, wenn die wärmebehandelte Schicht unmittelbar nach der Wärmebehandlung vor oder während dem Abkühlen lichtgehärtet wird.

Die Bestrahlung der wärmebehandelten Schicht zur Härtung erfolgt mit aktinischem Licht im allgemeinen im Wellenlängenbereich von 230 bis 600 nm, vorzugsweise im Wellenlängenbereich von 300 bis 420 nm. Für die Bestrahlung kommen die üblichen, aktinisches Licht in dem genannten Wellenlängenbereich emittierenden Lichtquellen in Betracht, wie Kohlebogenlampen, Quecksilberdampflampen, Xenonlampen, superaktinische Leuchtstoffröhren oder Impulsstrahler. Die Bestrahlungsdauer liegt im allgemeinen im Bereich von 1 Sekunde bis 12 Minuten, vorzugsweise im Bereich von 5 Sekunden bis 5 Minuten.

Die Bestrahlung der wärmebehandelten Schicht mit dem aktinischen Licht kann vollflächig oder bildmäßig, z. B. durch eine photografische Negativvorlage, erfolgen. Bei der vollflächigen Bestrahlung wird die gesamte Schicht gehärtet, so daß diese Verfahrensvariante für die Herstellung von Überzügen, Beschichtungen, selbsttragenden Schichten, Filmen oder Folien, wie sie beispielsweise als Ausgleich- oder Unterlagschichten, Zurichtefolien etc. zur Anwendung gelangen, zum Zuge kommt. Bei der Bestrahlung durch eine photografische Bildvorlage wird nur in den bilmäßig belichteten Schichtanteilen eine Photopolymerisation ausgelöst und werden somit auch nur diese Schichtanteile gehärtet. Die unbelichteten, ungehärteten Schichtanteile können anschließend in an sich bekannter Weise, insbesondere durch Auswaschen mit einem Entwicklerlösungsmittel, unter Ausbildung einer Reliefstruktur oder eines Resistmusters entfernt werden. Als Entwicklerlösungsmittel kommen, je nach Art der in der Schicht enthaltenen polymeren Bindemittel (a) sowie auch der weiteren Schichtbestandteile, organische Lösungsmittel, insbesondere Alkohole oder Alkohol/Wasser-Gemische, aber auch wäßrige Systeme, insbesondere Wasser selber, in Betracht. Nach der Entfernung der unbelichteten Schichtanteile können die gehärteten Bereiche gegebenenfalls getrocknet und nachbelichtet werden. Die bildmäßige Belichtung und Härtung der Schicht eignet sich zur Herstellung von Druck- und Reliefformen, insbesondere für den Hoch- oder Tiefdruck, wie auch für die Herstellung von Resistmustern oder Offset-Druckplatten.

Durch die Bestrahlung der wärmebehandelten Schicht wird hierin die Photopolymerisation initiiert und die Schicht unter Vernetzung der Bestandteile, insbesondere des polymeren Bindemittels (a) sowie der gegebenenfalls enthaltenen niedermolekularen polymerisierbaren Verbindungen (b), gehärtet. Es hat sich gezeigt, daß bei dieser durch die Bestrahlung mit dem aktinischem Licht initiierten Härtung der Schicht das teilkristalline polymere Bindemittel (a) in dem Zustand, in dem es nach der Wärmebehandlung vorliegt, dauerhaft fixiert wird. Da das teilkristalline polymere Bindemittel (a) wesentlichen Einfluß auf die Härte und Elastizität der lichtgehärteten Schichten hat, ist es nach dem erfindungsgemäßen Verfahren möglich, in Abhängigkeit von Art und Umfang der Wärmebehandlung lichtgehärtete Schichten mit unterschiedlicher, definierter Härte herzustellen, ohne daß es hierzu einer Änderung der Menge und/oder der Art der die härtbare Schicht bildenden Mischungsbestandteile bedarf. Beispielsweise ist es möglich, bei Einsatz von Polyurethanen als teilkristallinen, polymeren Bindemitteln (a) die Shore A-Härte der lichtgehärteten Schichten in Abhängigkeit von Dauer und Temperatur der Wärmebehandlung in einem Bereich von 50 bis 90 zu variieren.

Die Erfindung wird durch die nachfolgenden Beispiele näher erläutert. Die in den Beispielen genannten Teile und Prozente beziehen sich, sofern nicht anders vermerkt, auf das Gewicht. Die angegebenen K-Werte wurden 1 %-ig in Dimethylformamid gemessen. Die Shore A-Härte wurde ermittelt nach DIN 53 505, Reißfestigkeit und Reißdehnung nach DIN 53 504.

**Beispiel 1**

1.1 In 600 g Tetrahydrofuran wurden 400 g Polyethylenoxid (Molekulargewicht ca. 1000), 32,15 g einer 70 %-igen acetonischen Lösung des Diacrylats von Bisphenol A-Diglycidylether und 31,5 g Butandiol-1,4 unter Rühren bei Raumtemperatur gelöst. Nach Zugabe von 1,1 g Dibutylzinndilaurat wurden 148,7 g Hexamethylendiisocyanat zugegeben, wobei die Temperatur auf ca. 60°C anstieg. Nach 90 Minuten wurde die Reaktionsmischung mit 415 g Tetrahydrofuran verdünnt. Nach weiteren 15 Minuten wurden durch Zugabe von 40 g Methanol noch eventuell vorhandene Isocyanatgruppen desaktiviert. Das auf diese Weise erhaltene Polyetherurethan mit seitenständigen Acryloyl-Gruppen wies einen K-Wert von

8

0 136 452

56 und eine Shore A-Härte von 80 auf.

1.2 78,5 Teile des gemäß 1.1 hergestellten Polyurethans wurden zusammen mit 20 Teilen eines präpolymeren Urethandiacrylats (Zusammensetzung: 1 ÄG eines Polyesterdiols, 2 ÄG Isophorondiisocyanat, 2 ÄG Hydroxyethylacrylat), 1,5 Teilen Benzildimethylketal, 0,02 Teilen Zaponechtschwarz RE (C.I. 12195, Solvent black 34), 0,25 Teilen des Kaliumsalzes des N-Nitrosocyclohexylhydroxylamins und 0,025 Teilen sek.-Butylthioanthrachinon in Tetrahydrofuran bei 50°C unter Rühren zu einer ca. 50 %-igen Lösung gelöst und in solcher Schichtstärke auf eine Polyesterfolie aufgegossen, daß nach 1-stündigem Trocknen bei 60°C eine Schicht mit einer Dicke von 0,7 mm zurückblieb. Mit der freien Oberfläche wurde die so erzeugte photopolymerisierbare, lichthärtbare Schicht auf eine zuvor mit einem handelsüblichen Polyurethanlack behandelte Metallträgerplatte aufkaschiert.

1.3 Drei verschiedene Proben der gemäß 1.2 hergestellten Rohplatte wurden jeweils 10 Minuten bei einer Temperatur von 60, 80 bzw. 100°C in einem Wärmeumluftofen getempert. Nach Abkühlung der einzelnen Proben auf Raumtemperatur wurden die Polyesterfolien von der photopolymerisierbaren, lichthärtbaren Schicht abgezogen und alle 3 Proben in der gleichen Weise durch ein photografisches Negativ 4 Minuten lang mit einem handelsüblichen Flachbelichter (40 Watt UV-Fluoreszenzlampen) bildmäßig belichtet. Anschließend wurden die belichteten Platten mit einem Ethanol/Wasser-Gemisch ausgewaschen, wobei die unbelichteten Schichtanteile herausgelöst wurden. Die erhaltenen Reliefformen wurden anschließend 30 Minuten bei 60°C getrocknet und vollflächig nachbelichtet.

Die Härte, Reißdehnung und Reißfestigkeit der Reliefschichten der so erhaltenen Reliefformen sind in der nachfolgenden Tabelle wiedergegeben. In Abhängigkeit von der bei der Wärmebehandlung eingestellten Temperatur konnten unterschiedliche Härtegrade der Reliefschichten erhalten werden. Diese Härtegrade waren sehr gut reproduzierbar und blieben auch bei Lagerung und Gebrauch der Reliefformen unverändert. Die erhaltenen Reliefformen eigneten sich ausgezeichnet als Druckplatten für Farben auf Mineralölbasis. Die härtere Platte (Temperatur der Wärmbehandlung 60°C) eignete sich insbesondere für die Drucke von Strichmotiven; die weich eingestellte Platte (Temperatur der Wärmebehandlung 100°C) wurde bevorzugt für den Druck von Rastermotiven verwendet. Die Drucke zeigten eine exakte Wiedergabe der Vorlage mit randscharfen Details. Die Elastizität der Druckformen war sehr gut.

**Tabelle**

| | Temp. der Wärmebeh. | Shore A- -Härte | Reißdehnung [%] | Reißfestigkeit N/mm$^2$ |
|---|---|---|---|---|
| Probe a | 60°C | 78 | 36 | 9,1 |
| Probe b | 8°C | 73 | 41 | 7,8 |
| Probe c | 100°C | 65 | 38 | 6,6 |

**Vergleichsversuch A**

Es wurde genau wie in Beispiel 1 verfahren, diesmal jedoch auf die Wärmebehandlung der photopolymerisierbaren, lichthärtbaren Schicht vor der bildmäßigen Belichtung verzichtet. Die Reliefschicht der erhaltenen Reliefform wies eine Shore A-Härte von 82 auf.

**Beispiel 2**

In diesem Beispiel wurde zur Herstellung der photopolymerisierbaren, lichthärtbaren Schicht ein Polyurethan mit seitenständigen Acryloyl-Gruppen eingesetzt, das analog Beispiel 1.1 aus folgenden Verbindungen hergestellt worden war: 400 g eines Polyethylenoxids mit einem Molekulargewicht von 1000, 89,6 g des Diacrylats von Bisphenol A-Diglycidylether, 31,5 g Butandiol-1,4 und 176 g Hexamethylendiisocyanat. Mit diesem Polyurethan wird gemäß 1.2 eine photopolymerisierbare Schicht auf einer Polyesterfolie hergestellt und auf die freie Oberfläche der photopolymerisierbaren Schicht eine weitere, mit einem handelsüblichen 2 Komponenten-Haftkleber beschichtete Polyesterfolie aufgewalzt.

Das so erhaltene Mehrschichtenelement wird in einem Wärmeumluftofen 10 Minuten lang bei einer Temperatur von 100°C gelagert. Anschließend wird die photopolyrisierbare Schicht gemäß Beispiel 1.3 durch ein photografisches Negativ belichtet, mit Ethanol/Wasser ausgewaschen, 60 Minuten bei 60°C getrocknet und anschließend 10 Minuten vollflächig nachbelichtet.

Die Reliefschicht der so erhaltenen Reliefform besaß eine Shore A-Härte von 65 sowie eine Reißfestigkeit von 8 N/mm$^2$ und Reißdehnung von etwa 70 %. Die erhaltene Reliefform wies ein hohes Auflösungsvermögen

**0 136 452**

auf und eignete sich bei hoher Auflagenbeständigkeit hervorragend als Druckplatte für den Flexodruck.

**Vergleichsbeispiel B**

Es wurde wie in Beispiel 2 gearbeitet, diesmal jedoch auf die Wärmebehandlung der photopolymerisierbaren, lichthärtbaren Schicht verzichtet. Die Reliefschicht der erhaltenen Reliefform wies eine Shore A-Härte von 85 auf.

**Beispiel 3**

Gemäß Beispiel 1.2 wurde eine photopolymerisierbare Schicht aus ,folgenden Bestandteilen hergestellt: 78,3 Teilen eines Polyurethan-Bindemittels (hergestellt aus Hexamethylendiisocyanat, Polyethylenglykol mit einem Molekulargewicht von 1000, Cyclohexandimethanol und dem Diacrylat von Bisphenol A-Diglycidylether), 20 Teilen des präpolymeren Urethandiacrylats von Beispiel 1.2, 1,2 Teilen Benzildimethylketal, 0,02 Teilen Neutralrot (C.I. 50040), 0,03 Teilen 2-sek.-Butylthioanthrachinon, 0,3 Teilen N-Nitrosocyclohexylamin-Kaliumsalz und 0,2 Teilen 2,6-Di-tert.-butyl-p-kresol. Die Dicke der hergestellten photopolymerisierbaren, lichthärtbaren Schicht betrug diesmal 0,45 mm.

So hergestellte photopolymerisierbare, lichthärtbare Schichten wurden unterschiedlich bei Temperaturen zwischen 60 und 100°C in einem Zeitraum von 10 bis 60 Minuten in einem Wärmeumluftofen gelagert und anschließend - nach Abkühlen auf Raumtemperatur - mit einer UV-Fluoreszenzlampe gemäß Beispiel 1 vollflächig belichtet. Es wurden gehärtete Schichten mit Shore A-Härten zwischen 65 bis 80 erhalten, wobei die unter den einzelnen Verfahrensbedingungen erhaltenen Härtegrade sehr gut reproduzierbar waren und die Härte der Schichten nach der Bestrahlung mit dem aktinischem Licht unverändert blieb.

Analog Beispiel 3 wurden lichthärtbare Schichten hergestellt, die als polymeres Bindemittel Polyamide, urethanmodifizierte Polyamide und Polyetherester, jeweils mit seitenständigen Acryloyl-Gruppen, enthielten. Diese Schichten wurden analog Beispiel 3 wärmebehandelt und durch Bestrahlung mit aktinischem Licht gehärtet. Es wurden entsprechende Ergebnisse wie in Beispiel 3 erhalten.

**Patentansprüche**

1. Verfahren zur Herstellung von lichtgehärteten Schichten mit definierter Härte durch Bestrahlen einer lichthärtbaren Schicht aus einer photopolymerisierbaren bzw. photovernetzbaren Mischung von

a) einem teilkristallinen, polymeren Bindemittel mit zur Photopolymerisation befähigten olefinischen Doppelbindungen,
b) gegebenenfalls einer oder mehreren Photopolymerisierbaren, olefinisch ungesättigten, niedermolekularen Verbindungen,
c) mindestens einem Photopolymerisationsinitiator, sowie gegebenenfalls
d) sonstigen üblichen Zusatz- und/oder Hilfsstoffen

mit aktinischem Licht, wobei man die lichthärtbare Schicht vor der Bestrahlung mit aktinischem Licht einer Wärmebehandlung unterwirft, dadurch gekennzeichnet, daß in der lichthärtbaren Schicht als teilkristallines polymeres Bindemittel (a) ein Polyetherester, Polyurethan, Polyurethanpolyharnstoff und/oder ein urethangruppenhaltiges Polyamid mit seitenständigen, vorzugsweise aktivierten, olefinischen Doppelbindungen enthalten ist und daß dabei die Wärmebehandlung so durchgeführt wird, daß keine chemische Vernetzung oder Härtung der lichthärtbaren Schicht erfolgt, sondern daß die teilkristallinen Bereiche des Polymeren Bindemittels (a) in Abhängigkeit von der angewandten Temperatur zumindest teilweise aufgeschmolzen werden.

2. Verfahren nach Anspruch 1, dadurch gekennzeichnet, daß die Wärmebehandlung bei Temperaturen im Bereich von 50 bis 130°C durchgeführt wird.

3. Verfahren nach einem der Ansprüche 1 oder 2, dadurch gekennzeichnet, daß die Wärmebehandlung Für eine Dauer von 1 bis 120 Minuten durchgeführt wird.

4. Verfahren nach einem der Ansprüche 1 bis 3, dadurch gekennzeichnet, daß in der lichthärtbaren Schicht als teilkristallines polymeres Bindemittel (a) ein Polyamid mit zur Polymerisation befähigten olefinischen Doppelbindungen enthalten ist.

5. Verfahren nach einem der Ansprüche 1 bis 4, dadurch gekennzeichnet, daß zur Herstellung von lichtgehärteten Überzügen, Beschichtungen, selbsttragenden Schichten, Folien oder Platten die lichthärtbare Schicht vollflächig mit aktinischem Licht belichtet wird.

6. Verfahren nach einem der Ansprüche 1 bis 4, dadurch gekennzeichnet, daß zur Herstellung von Relief-

10

oder Druckformen oder Resistmustern die lichthärtbare Schicht bildmäßig mit aktinischem Licht belichtet wird, anschließend die unbelichteten, ungehärteten Schichtanteile mit einem Entwicklerlösungsmittel ausgewaschen werden und die verbleibenden, gehärteten Schichtanteile gegebenenfalls getrocknet und nachbelichtet werden.

## Claims

1. A process for the production of a photocured layer possessing a defined hardness, comprising exposure of a photocurable layer, which consists of a photopolymerizable or photocrosslinkable mixture containing

a) one or more partially crystalline, polymeric binders possessing olefinic double bonds capable of undergoing photopolymerization,

b) if required, one or more photopolymerizable, olefinically unsaturated, low molecular weight compounds and

c) one or more photopolymerization initiators, with or without

d) other conventional additives and/or assistants,

to actinic light, in which the photocurable layer, prior to exposure to actinic light, is subjected to a heat treatment, wherein the partially crystalline polymeric binder (a) employed in the photocurable layer contains a polyether ester, polyurethane, polyurethane-polyurea and/or a urethane-containing nylon possessing olefinic double bonds, preferably activated, in side groups and wherein the heat treatment is carried out in such a way that chemical crosslinking or curing of the photocurable layer does not take place and that instead the partially crystalline parts of the polymeric binder (a) become partially or completely fused, depending on the temperature used.

2. A process as claimed in claim 1, wherein the heat treatment is carried out at from 50 to 130°C.

3. A process as claimed in either of claims 1 or 2, wherein the heat treatment is carried out for from 1 to 120 minutes.

4. A process as claimed in any of claims 1 to 3, wherein the partially crystalline polymeric binder (a) employed in the photocurable layer is a nylon possessing olefinic double bonds capable of undergoing polymerization.

5. A process as claimed in any of claims 1 to 4, wherein the photocurable layer is exposed uniformly to actinic light in order to produce the photocured coating, self-supporting layer, film or sheet.

6. A process as claimed in any of claims 1 to 4, wherein, in order to produce a relief or printing plate or a resist image, the photocurable layer is exposed imagewise to actinic light, the unexposed uncured areas of the layer are then washed out with a developer, and the remaining, cured areas of the layer are, if required, dried and post-exposed.

## Revendications

1. Procédé de préparation de couches photodurcies à dureté déterminée par exposition d'une couche photodurcissable consistant en un mélange photopolymérisable ou photoréticulable de

a) un liant polymère partiellement cristallin contenant des doubles liaisons oléfiniques aptes à une photopolymérisation,

b) le cas échéant un ou plusieurs composés à insaturation oléfinique photopolymérisables à bas poids moléculaire.

c) au moins un inducteur de photopolymérisation et, le cas échéant,

d) d'autres additifs et/ou produits auxiliaires usuels,

à de la lumière actinique, dans lequel on soumet la couche photodurcissable avant l'exposition à la lumière actinique à un traitement à la chaleur, caractérisé en ce que la couche photodurcissable contient, en tant que liant polymère partiellement cristallin a), un polyéther-ester, un polyuréthanne, une polyuréthanne-polyurée et/ou un polyamide contenant des groupes uréthanne à doubles liaisons oléfiniques latérales de préférence activées et en ce que le traitement à la chaleur est effectué de manière à éviter un durcissement ou une réticulation chimique de la couche photodurcissable mais à fondre, en partie au moins selon la température observée, les régions partiellement cristallines du liant polymère a).

2. Procédé selon la revendication 1, caractérisée en ce que le traitement à la chaleur est effectué à des températures dans l'intervalle de 50 à 130°C.

3. Procédé selon l'une des revendications 1 ou 2, caractérisé en ce que le traitement à la chaleur dure de 1 à 120 minutes.

4. Procédé selon l'une des revendications 1 à 3, caractérisé en ce que le liant polymère partiellement cristallin a) contenu dans la couche photodurcissable est un polyamide contenant des doubles liaisons oléfiniques aptes à une polymérisation.

5. Procédé selon l'une des revendications 1 à 4, caractérisé en ce que, pour la formation de revêtements, enduits, couches cohérentes, feuilles ou plaques photodurcis, on expose la couche photodurcissable sur toute sa surface à la lumière actinique.

6. Procédé selon l'une des revendications 1 à 4, caractérisé en ce que, pour la formation de formes en relief ou de formes d'impression ou de modèles de réserve, on expose la couche photodurcissable, selon une image, à la lumière actinique, on élimine ensuite les parties de la couche non exposées et non durcies à l'aide d'un solvant révélateur et, le cas échéant, on sèche et on expose à nouveau les parties restantes, durcies, de la couche.